# EUROPÄISCHE PATENTSCHRIFT

(11) **EP 0 296 348 B1**
(45) Veröffentlichungstag und Bekanntmachung des Hinweises auf die Patenterteilung: **31.03.1993**
(21) Anmeldenummer: 88107530.3
(22) Anmeldetag: 10.05.1988
(51) Int. Cl.: H01L 21/306

(54) **Ätzverfahren zum Erzeugen von Lochöffnungen oder Gräben in n-dotiertem Silizium**
Process for etching holes or grooves in n-type silicium
Procédé d'attaque pour creuser des trous ou des sillons dans du silicium de type n

(30) Priorität: 27.05.1987 DE 3717851
(43) Veröffentlichungstag der Anmeldung: 28.12.1988
(73) Patentinhaber: SIEMENS AKTIENGESELLSCHAFT, 80333 München (DE)
(72) Erfinder: Föll, Helmut, Dr., D-8000 München 80 (DE); Lehmann, Volker, D-8000 München 80 (DE)

(56) Entgegenhaltungen:
- EP-A- 0 018 556
- EP-A- 0 045 446
- EP-A- 0 178 387
- DE-A- 1 421 973
- DE-A- 1 901 388
- FR-A- 1 548 079
- FR-A- 2 339 953
- US-A- 3 471 922
- US-A- 3 801 390
- IEEE ELECTRON DEVICE LETTERS, Band EDL-4, Nr. 11, November 1983, Seiten 411-414, IEEE, New York, US; T. MORIE et al.: "Depletion trench capacitor technology for megabit level MOS dRAM"

## Beschreibung

Die Erfindung betrifft ein Verfahren zum Erzeugen von Lochöffnungen oder Gräben in aus n-dotiertem Silizium bestehenden Schichten oder Substraten, wie sie bei der Herstellung von Halbleiterbauelementen, insbesondere hochintegrierten Halbleiterschaltungen, verwendet werden, durch maskiertes Einätzen.

Silizium als wichtigster Werkstoff der Mikroelektronik erfordert immer gezieltere und speziellere Verfahren zur Oberflächenstrukturierung. Das Erzeugen von Gräben bzw. Löchern in der Siliziumoberfläche ist hierbei ein zentrales technisches Problem.

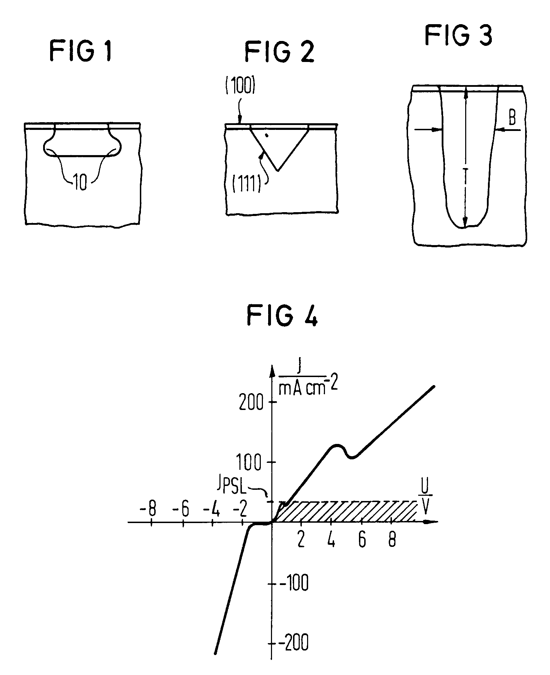

Bisher werden chemische Ätzverfahren oder Plasmaätzverfahren zur Erzeugung von loch- oder grabenförmigen Strukturen verwendet. Dabei treten folgende Schwierigkeiten auf:
a) Beim isotropen chemischen Ätzen (sauer) treten Unterätzungen (10) auf, die die möglichen Ätzgeometrien sehr beschränken (siehe Figur 1).
b) Beim anisotropen chemischen Ätzen (alkalisch) ist durch die Kristallflächen (111) und (100) die Anzahl der realisierbaren Ätzgeometrien stark eingeschränkt (siehe Figur 2).
c) Beim Plasmaätzen, wie es beispielsweise zur Realisierung der Grabenzellen von Mbit-Speichern in einem Bericht von Morie et. al. aus dem IEEE Electron Device Letters, Vol.-EDL-4, Nr. 11 (November 1983), auf den Seiten 411 bis 414 zu entnehmen ist, sind Abmessungen unter 1 µm, sowie Tiefe/Breite-Verhältnisse T/B größer 10 bei Löchern nur sehr schwierig erreichbar (siehe Figur 3). Der rechtwinklige Grabenquerschnitt ist bei Morie vom Gasdruck des Reaktionsgases (Trifluorbrommethan) stark abhängig.

Durch die Erfindung soll die Aufgabe gelöst werden, Lochgeometrien und Gräben kontrolliert durch ein Ätzverfahren in möglichst einfacher Weise herzustellen, wobei sowohl Löcher und Gräben im Silizium für die Mikroelektronik (Durchmesser kleiner 1 µm, 10 µm tief), als auch solche für die Leistungsbauelemente-Elektronik mit beliebigen Querschnitten erzeugt werden sollen. Außerdem soll es auch möglich sein, feine Gräben (Perforationen) für die Aufnahme von Dotierstoffen im Silizium zu erzeugen.

Die Lösung der erfindungsgemäßen Aufgabe erfolgt dadurch, daß eine elektrolytische Ätzung in einem flußsäurehaltigen Elektrolyten unter Anlegung eines konstanten oder sich zeitlich ändernden Potentials durchgeführt wird gemäß Anspruch 1.

Es liegt im Rahmen der Erfindung, die Elektrolyse durch Bleuchtung des Siliziumkörpers von der Rückseite her zu injizieren und die Beleuchtung konstant oder zeitlich variiert aufrechtzuerhalten, um den Ätzstrom durch die Bildung von Minoritätsladungsträgern zu steuern.

Es hat sich außerdem als vorteilhaft erwiesen, zusätzlich vor und/oder nach der elektrolytischen Ätzung eine chemische Ätzung vorzugsweise in Kalilauge durchzuführen, wobei ein Netzmittel zugesetzt werden kann.

Zusätzlich kann der Siliziumkörper außer dem zu ätzenden Elektrolytkontakt einen ohmschen Kontakt oder einen weiteren Elektrolytkontakt (Kontakt für die Majoritätsladungsträger) aufweisen.

Weitere Ausgestaltungen der Erfindung ergeben sich aus den Unteransprüchen.

Im folgenden soll auf die Physik des erfindungsgemäßen Verfahrens am Beispiel des elektrolytischen Löcherätzens im n-dotierten Silizium noch näher eingegangen werden.

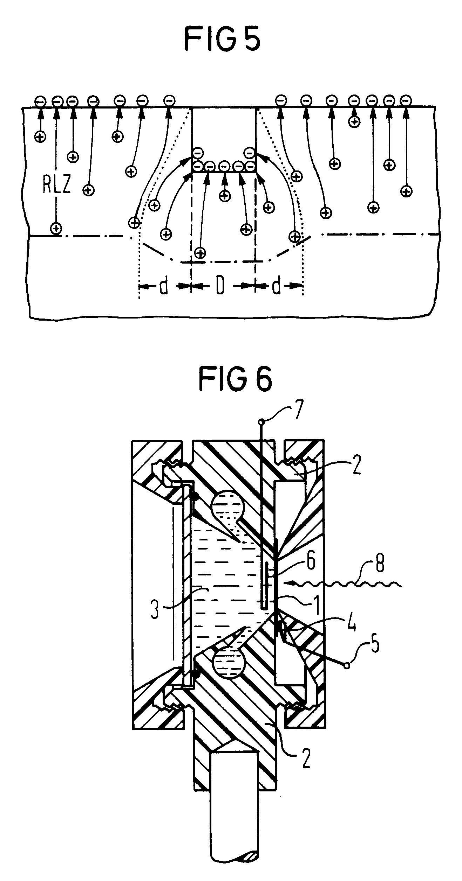

Die Figur 4 zeigt die prinzipielle I-U-Kennlinie des Flußsäure-Elektrolyt-n-Silizium-Kontaktes. Im schraffierten Gebiet erfolgt als anodische Elektrodenreaktion die divalente Auflösung (I kleiner I_{PSL}) des Siliziums ohne Bildung einer elektropolierenden Oberflächenschicht, wie sie im tetravalenten Auflösungsbereich (I größer I_{PSL}) auftritt, das heißt die gesamte angelegte Spannung fällt über der Raumladungszone (RLZ) ab (PSL bedeutet Porous Silicon Layer; diese Schicht bildet sich im anodischen Bereich in Flußsäure auf p- und n-Silizium). Ein elektrischer Strom fließt jedoch nur, wenn Minoritätsladungsträger (Löcher h⁺) vorhanden sind. Diese können durch Beleuchtung erzeugt werden, der Strom ist damit eine Funktion des einfallenden Lichtes. Diese speziellen Eigenschaften der n-Si-Elektrode bei nicht zu großen Stromdichten führt dazu, daß kleine Abweichungen von der ideal glatten Oberfläche sich aufschaukeln, das heißt, ein minimales Loch bzw. eine Ätzgrube verbiegt das elektrische Feld der Raumladungszone gerade so, daß alle nahen h⁺ von diesem Loch gesammelt werden und damit die Ätzung verstärkt am Lochboden erfolgt. Wie aus Figur 5 ersichtlich ist, sammelt das Loch der Breite D Ladungsträger aus dem Bereich D + 2d. Nach einiger Zeit bildet sich durch den beschriebenen Prozeß ein System feiner, eng benachbarter Löcher. Diese mikroskopische Wabenoberfläche absorbiert Licht sehr stark, das heißt, ist makroskopisch tief schwarz.

Durch eine geeignete Maske und einer Vorätzung mit zum Beispiel Kalilauge können die erwähnten kleinen Abweichungen vorgegeben werden und damit die Löcher lokalisiert werden. Ein einzelnes Loch wird durch die spezielle Form der Raumladungszone sich verzweigen und so eine baumartige Lochstruktur bilden, während ein gleichmäßiges Muster von Löchern durch gegenseitige Beeinflussung zu einer streng vertikalen Wachstumsrichtung führt. Die Form und Abmessung der Löcher ist stark variierbar und von folgenden Parametern abhängig:
1. Die Lochanordnung (Maske) bestimmt über die Wirkung auf die Raumladungszone stark die Geometrie der Löcher (Verzweigung oder Linearität).
2. Die Vorätzung mit Kalilauge verbessert nur die durch die Maske vorgegebenen kleinen Abweichungen von der ideal glatten Oberfläche (Keim) und wirkt sich nur auf die Form des oberen Lochrandes aus.
3. Das angelegte Potential zwischen Silizium und Referenzelektrode (Spannung) bestimmt das elektrische Feld in der Raumladungszone und damit die Wandrauhigkeit der Löcher (bei Spannungen im Bereich der Durchbruchfeldstärke sind die Löcher spitz und schmal und die Lochwand ist stark durch feine Kanäle (Spitzenentladungen) gestört).
4. Der Ätzstrom durch die Probenoberfläche ist eine Funktion des einfallenden Liches; er bestimmt hauptsächlich die Lochbreite, hat aber auch Einfluß auf den Durchbruchmechanismus.
5. Die Lochtiefe ist näherungsweise proportional zur Ätzdauer.
6. Die Dotierung des Substrats bestimmt die Ausdehnung und das Feld in der Raumladungszone. Aus Scaling-Regeln läßt sich ableiten, daß sich bei Vervierfachung der Dotierung die geometrischen Abmessungen der Löcher um den Faktor 2 vergrößern.
7. Die Einflüsse der Flußsäure-Konzentration und der Temperatur sind noch nicht eingehend untersucht, werden jedoch als eher gering eingeschätzt.
8. Eine Nachätzung, zum Beispiel in Kalilauge, dient einmal zur Entfernung der sich prozeßbedingt bildenden porösen Siliziumschicht (= PSL in Figur 4), oder zum anderen, um feinstrukturierte Kanäle zu gröberen Strukturen zum Beispiel zu Gräben zu verbinden.

Weitere Einzelheiten der Erfindung insbesondere ihre Anwendung werden anhand von fünf Ausführungsbeispielen und der Figuren 6 bis 11 im folgenden noch näher beschrieben.

Dabei zeigt
- die Figur 6: schematisch den Ätzprozeß in einer Elektrolysierzelle, wobei im Schnittbild ein Probenhalter zur Durchführung der elektrolytischen Ätzung abgebildet ist.
- In den Figuren 7 bis 11: sind Schnittbilder durch die nach dem Ätzen erhaltenen Strukturen dargestellt.

Figur 6: Mit dem Bezugszeichen 1 ist eine aus n-dotiertem Silizium bestehende Siliziumkristallscheibe bezeichnet, in deren mit einer Maskierschicht versehenen Oberfläche die Strukturen (Löcher oder Gräben) erzeugt werden sollen. Diese Siliziumkristallscheibe 1 ist in einem aus Teflon bestehenden Probenhalter 2 eingespannt, der so ausgebildet ist, daß er in seinem Inneren den aus Flußsäurelösung bestehenden Elektrolyten 3 dicht verschlossen enthält. Über einen ohmschen Kontakt 4 wird die Siliziumkristallscheibe 1 mit dem positiven Pol 5 einer Spannungsquelle (nicht abgebildet) verbunden. Die Gegenelektrode 6 (negativer Pol 7 = Kathode) besteht aus einem gegenüber Flußsäure resistenten Material, zum Beispiel aus Platin. Um die benötigte Stromdichte zu erreichen, wird die Siliziumkristallscheibe 1 mit Licht geeigneter Intensität (siehe gewellter Pfeil 8) von der Rückseite her beleuchtet. Unter diesen Bedingungen erfolgt bei angelegter Spannung anodische Auflösung an den nicht mit der Maskierschicht (nicht dargestellt) bedeckten Oberfläche der Siliziumkristallscheibe 1. Die Tiefe der Ätzgräben oder -löcher wird vorwiegend über die Ätzzeit eingestellt.

### Erstes Ausführungsbeispiel:

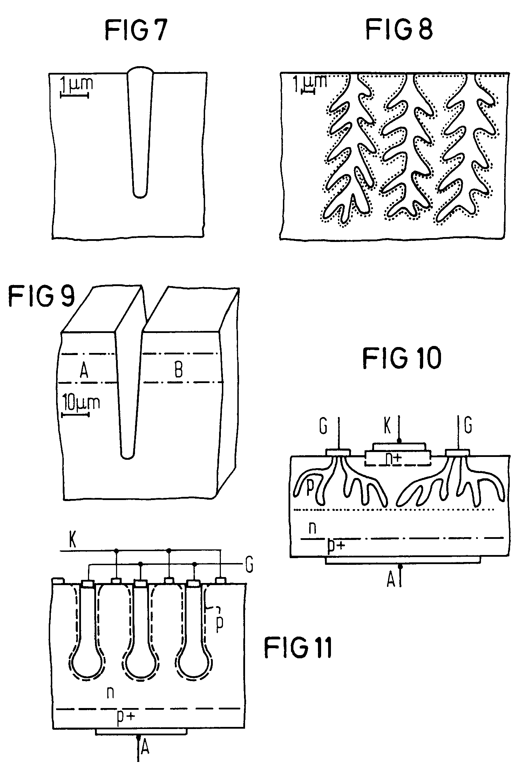

Herstellung von Löchern in Speicherbausteinen wie zum Beispiel Trenchzellen (siehe Figur 7).

Es sollen Löcher in n-Silizium mit 1 µm Durchmesser und 10 µm Tiefe hergestellt werden, die zur Aufnahme des Varaktors oder des Varaktors und Auswahltransistors eines DRAMs (= dynamic random access memory) dienen. Dazu wird in einem ersten Arbeitsschritt in konventioneller Technik eine zum Beispiel aus Siliziumnitrid bestehende Maske auf einer n-dotierten Siliziumkristallscheibe aufgebracht. Die durch die Maske vorgegebene Anordnung der Löcher wird nun mit einer alkalischen Ätze, zum Beispiel 10 %iger Kalilauge 10 Minuten vorgeätzt (siehe Figur 2). Im weiteren Verlauf wird die Siliziumkristallscheibe in der in Figur 6 dargestellten oder einer für Produktionszwecke modifizierten Anordnung eingespannt.

Die elektrolytische Ätzung in einer Flußsäurelösung (2,5 Gewichtsprozent), die mit einem Netzmittel auf Formaldehydbasis (Mirsaol^{R}, 3 Tropfen pro Liter) versetzt ist, erfolgt nun unter folgenden Parametern (die in den folgenden Ausführungsbeispielen genannten Parameter sind nur grobe Richtwerte, die je nach Anwendung optimiert und zeitlich variiert werden müssen):

Das Potential zwischen Referenzelektrode und ohmschem Probenkontakt wird auf U = 1V (positiver Pol an Probe) eingestellt.

Der Ätzstrom pro Loch beträgt 0,1 nA, eingestellt durch Beleuchtung der Rückseite mit Licht, zum Beispiel 800 nm Wellenlänge, (Strom I zeitlich konstant oder abnehmend je nach zu produzierender Lochform).

Die Dauer der Ätzung t beträgt 20 Minuten. Das n-dotierte Substrat weist eine Dotierung Nₙ von 1 Ohm cm und eine Orientierung in (100)-Richtung auf.

Die Ätzung erfolgt bei Raumtemperatur.

Abschließend erfolgt eine Nachätzung von 10 Minuten in 1 %iger Kalilauge zur Entfernung der beim Ätzen sich bildenden porösen Siliziumschicht (in Figur 4 als PSL bezeichnet).

### Zweites Ausführungsbeispiel:

Herstellung von tiefen, vertikalen Dotierungen (eventuell durch die ganze Siliziumkristallscheibendicke) bei geringer horizontaler Dotiertiefe (siehe Figur 8), sowie Herstellung großflächiger Kondensatoren oder pn-Übergänge (zum Beispiel für steuerbare Kondensatoren (Varicaps) großer Kapazität) in kleinem Volumen.

Die Vor- und Nachbehandlung in Kalilauge erfolgt wie im ersten Ausführungsbeispiel beschrieben; für die Konzentration des Elektrolyten und die Beleuchtung gelten analoge Werte.

Das Potential zwischen Referenzelektrode und ohmschem Probenkontakt wird auf U = 2V, der Ätzstrom I auf 1 nA, die Ätzzeit t auf 100 Minuten und die Dotierung auf Nₙ auf einen Bereich von 0,1 bis 1 Ohm cm eingestellt.

Die anschließende Dotierung (siehe strichlierte Linie in Figur 8) erfolgt mit konventioneller Technik.

### Drittes Ausführungsbeispiel:

Herstellung von tiefen, schmalen Gräben zur elektrischen Isolation von Bereichen A und B (siehe Figur 9) in einem Si-Substrat.

Es gelten die gleichen Parameter wie bei den Ausführungsbeispielen 1 und 2 beschrieben, mit Ausnahme von:

Das Potential zwischen Referenzelektrode und ohmschen Probenkontakt wird auf U = 2 bis 20V, der Ätzstrom I auf 1 nA und die Ätzzeit t auf 100 Minuten eingestellt. Die Dotierung Nₙ liegt im Bereich zwischen 1 bis 100 Ohm cm.

Die Nachätzung in Kalilauge wird verstärkt, um die einzelnen durch die Maske vorgegebenen Löcher zu einem geschlossenen Graben zu verbinden. Dies erfolgt entweder durch längere Ätzzeit und/oder durch höhere Konzentrationen und/oder durch höhere Temperatur der KOH-Lösung.

### Viertes Ausführungsbeispiel:

Kontaktierung tiefer liegender Schichten, zum Beispiel zum schnellen Ausräumen von Ladungsträgern in abschaltbaren (GTO = gate turn off)-Thyristoren (siehe Figur 10).

Es gelten die gleichen Parameter wie bei den Ausführungsbeispielen 1 bis 3 mit Ausnahme von:

Das Potential zwischen Referenzelektrode und ohmschem Probenkontakt wird auf U = 2V, der Ätzstrom I auf 1 bis 100 nA und die Ätzzeit t auf 100 Minuten eingestellt. Die Dotierung Nₙ liegt im Bereich zwischen 1 bis 100 Ohm cm. Im p-Gebiet vorhandene Minoritätsladungsträger werden durch die geätzten und eventuell metallisierten Kanäle ausgeräumt.

Mit den Buchstaben A, K und G sind die Anode, Kathode und das Gate der Thyristoren bezeichnet.

### Fünftes Ausführungsbeispiel:

Herstellung spannungsgesteuerter Thyristoren (siehe Figur 11).

Es gelten die gleichen Parameter wie bei den Ausführungsbeispielen 1 bis 4 beschrieben mit Ausnahme von: Das Potential zwischen Referenzelektrode und ohmschen Kontakt wird auf U = 2V, die Ätzzeit auf 100 Minuten und die Dotierung Nₙ auf einen Bereich zwischen 10 bis 100 Ohm cm eingestellt. Nach zwei Drittel der Ätzzeit erfolgt eine Erhöhung des Ätzstromes I im Bereich von 1 bis 100 nA um den Faktor 2 bis 10, wodurch die Lochaufweitung erreicht wird.

Durch die spannungsabhängige Vergrößerung der Raumladungszone um die Löcher wird der Strom zwischen der Anode A und Kathode K des Bauelements gesteuert. Mit G sind die Gateanschlüsse bezeichnet.

## Patentansprüche

1. Verfahren zum Erzeugen von Lochöffnungen oder Gräben in aus n-dotierten Silizium bestehenden Schichten oder Substraten, wie sie bei der Herstellung von Halbleiterbauelementen, insbesondere hochintegrierten Halbleiteschaltungen, verwendet werden, durch vorzugsweise maskiertes Einätzen, bei dem eine elektrolytische Ätzung in einem flußsäurehaltigen Elektrolyten (3) unter Anlegung eines konstanten oder sich zeitlich ändernden Potentials durchgeführt wird, wobei die aus Silizium bestehende Schicht oder das Substrat (1) als positiv gepolte Elektrode (5) einer Elektrolysierzelle geschaltet wird, und bei dem zur Injizierung der Elektrolyse notwendige Minoritätsladungsträger im Silizium erzeugt werden und die Ätzung bei nicht zu großen Stromdichten im Bereich der divalenten Auflösung von Silizium zunächst an kleinen Abweichungen von der ideal glatten Oberfläche des Siliziums erfolgt, sich dort verstärkt und ein System feiner Löcher bildet.

2. Verfahren nach Anspruch 1,
**dadurch gekennzeichnet,**
daß die kleinen Abweichungen durch eine Ätzmaske vorgegeben werden.

3. Verfahren nach Anspruch 2, **dadurch gekennzeichnet,** daß als Ätzmaske eine strukturierte Siliziumnitridschicht verwendet wird.

4. Verfahren nach einem der Anspruch 1 bis 3, **dadurch gekennzeichnet,** daß zusätzlich vor und/oder nach der elektrolytischen Ätzung eine chemische Ätzung, vorzugsweise in Alkalilauge, durchgeführt wird.

5. Verfahren nach einem der Ansprüche 1 bis 4, **dadurch gekennzeichnet,** daß dem Elektrolyten (3) ein Netzmittel zugesetzt wird.

6. Verfahren nach Anspruch 5, **dadurch gekennzeichnet,** daß ein Netzmittel auf Formaldehydbasis verwendet wird.

7. Verfahren nach einem der Ansprüche 1 bis 6, **dadurch gekennzeichnet,** daß die Elektrolyse durch Beleuchtung (8) des Siliziumkörpers (1) von der Rückseite injiziert wird.

8. Verfahren nach Anspruch 7, **dadurch gekennzeichnet,** daß die Beleuchtung (8) konstant oder zeitlich variiert aufrechterhalten wird, um den Ätzstrom zu steuern.

9. Verfahren nach einem der Ansprüche 1 bis 8, **dadurch gekennzeichnet,** daß die Flußsäurekonzentration im Elektrolyten (3) auf ungefähr 2,5 Gewichtsprozent eingestellt wird.

10. Verfahren nach einem der Ansprüche 1 bis 9, **dadurch gekennzeichnet,** daß bei der Ätzung ein zusätzlich zum Elektrolytkontakt (5) weiterer Kontakt (4) für die Majoritätsladungsträger verwendet wird.

11. Verfahren nach Anspruch 10, **dadurch gekennzeichnet,** daß als Kontakt (4) ein ohmscher Kontakt verwendet wird.

12. Verfahren nach einem der Ansprüche 1 bis 11, **dadurch gekennzeichnet,** daß zur Herstellung von Löchern mit einem Durchmesser von ca. 1 µm und einer Tiefe von ca. 10 µm in einem n-dotierten Siliziumsubstrat im Bereich von 1 Ohm cm der Ätzstrom pro Loch auf 0,1 nA, die Spannung auf 1 V und die Ätzzeit auf 20 Minuten eingestellt wird.

13. Verfahren nach einem der Ansprüche 1 bis 11, **dadurch gekennzeichnet,** daß zur Herstellung von Dotierstoffe aufnehmenden feinporigen Gräben sowie zur Herstellung großflächiger Kondensatoren oder pn-Übergänge im kleinen Volumen im n-dotierten Siliziumsubstrat im Bereich von 0,1 bis 1,0 Ohm cm der Ätzstrom auf 1 nA, die Spannung auf 2 V und die Ätzzeit auf 100 Minuten eingestellt wird.

14. Verfahren nach einem der Ansprüche 1 bis 11, **dadurch gekennzeichnet,** daß zur Herstellung von Gräben im n-dotierten Siliziumsubstrat im Bereich von 1 bis 100 Ohm cm für die Aufnahme von Isolationsmaterial mit einem Grabendurchmesser im Bereich von 5 um und einer Tiefe von ca. 20 µm der Ätzstrom auf 1 nA, die Spannung im Bereich von 2 bis 20 V und die Ätzzeit auf 100 Minuten eingestellt wird.

15. Verfahren nach einem der Ansprüche 4 bis 14, **dadurch gekennzeichnet,** daß die Nachätzung in 1 bis 10 gewichtsprozentiger Kalilauge mit einer Ätzzeit von 10 Minuten durchgeführt wird.

16. Verfahren nach einem der Ansprüche 4 bis 15, **dadurch gekennzeichnet,** daß die Vorätzung in 10 gewichtsprozentiger Kalilauge mit einer Ätzzeit von 10 Minuten durchgeführt wird.

17. Anwendung des Verfahrens nach mindestens einem der Ansprüche 1 bis 16 zur Herstellung von Gräben für die Aufnahme von Grabenzellenkondensatoren (Trenchzellen) für Speicherbausteine im sub-µm-Bereich.

18. Anwendung des Verfahrens nach mindestens einem der Ansprüche 1 bis 16 zur Herstellung von Isolationsgräben für hochintegrierte Halbleiterschaltungen.

19. Anwendung des Verfahrens nach mindestens einem der Ansprüche 1 bis 16 zur Herstellung von steuerbaren Kondensatoren (varicaps) großer Kapazität.

20. Anwendung des Verfahrens nach mindestens einem der Ansprüche 1 bis 16 zur Herstellung von Kontaktlöchern in tiefer liegenden Schichten in Siliziumhalbleitersubstraten, wie sie insbesondere bei abschaltbaren Thyristoren verwendet werden, wobei der Ätzstrom auf einen Bereich von 1 bis 100 nA, die Spannung auf 2 V und die Ätzzeit auf 100 Minuten eingestellt wird.

21. Anwendung des Verfahrens nach Anspruch 20 zur Herstellung von spannungsgesteuerten Thyristoren, wobei zur Lochaufweitung der Ätzstrom nach zwei Drittel der Ätzzeit um den Faktor 2 bis 10 erhöht wird.

22. Anwendung des Verfahrens nach mindestens einem der Ansprüche 1 bis 16 zur Herstellung großflächiger Kondensatoren in kleinem Volumen.

## Claims

1. Method of producing hole apertures or trenches in layers or substrates which comprise n-doped silicon and are used to manufacture semiconductor components, in particular LSI semiconductor circuits, by preferably masked etching, in which an electrolytic etching is carried out in an electrolyte (3) containing hydrofluoric acid by applying a constant potential or a potential which varies with time, the layer comprising silicon or the substrate (1) being connected as positively polarised electrode (5) of an electrolysis cell, and in which minority charge carriers necessary for the injection of the electrolysis are produced in the silicon and the etching is first carried out at small deviations from the ideally flat surface of the silicon at not unduly high current densities in the divalent dissolution region of silicon and is intensified at those points, and a system of fine holes is formed.

2. Method according to Claim 1, characterised in that the small deviations are provided by an etching mask.

3. Method according to Claim 2, characterised in that a patterned silicon nitride layer is used as etching mask.

4. Method according to one of Claims 1 to 3, characterised in that a chemical etching, preferably in alkali hydroxide solution, is additionally carried out before and/or after the electrolytic etching.

5. Method according to one of Claims 1 to 4, characterised in that a wetting agent is added to the electrolyte (3).

6. Method according to Claim 5, characterised in that a wetting agent based on formaldehyde is used.

7. Method according to one of Claims 1 to 6, characterised in that the electrolysis is injected by illuminating (8) the silicon body (1) from the back.

8. Method according to Claim 7, characterised in that the illumination (8) is maintained as constant or varying with time in order to control the etching current.

9. Method according to one of Claims 1 to 8, characterised in that the hydrofluoric acid concentration in the electrolyte (3) is adjusted to approximately 2.5% by weight.

10. Method according to one of Claims 1 to 9, characterised in that during the etching, a further contact (4) in addition to the electrolyte contact (5) is used for the majority charge carriers.

11. Method according to Claim 10, characterised in that an ohmic contact is used as contact (4).

12. Method according to one of Claims 1 to 11, characterised in that to manufacture holes having a diameter of approximately 1 µm and a depth of approximately 10 µm in an n-doped silicon substrate in the region of 1 ohm · cm, the etching current is adjusted for each hole to 0.1 nA, the voltage to 1 V and the etching time to 20 minutes.

13. Method according to one of Claims 1 to 11, characterised in that, to manufacture fine-pored trenches which receive dopant and to manufacture large-area capacitors or p-n junctions in a small volume in the n-doped silicon substrate in the range from 0.1 to 1.0 ohm · cm, the etching current is adjusted to 1 nA, the voltage to 2 V and the etching time to 100 minutes.

14. Method according to one of Claims 1 to 11, characterised in that, to manufacture trenches in the n-doped silicon substrate in the range from 1 to 100 ohm · cm having a trench diameter in the region of 5 µm and a depth of approximately 20 µm for the reception of insulating material, the etching current is adjusted to 1 nA, the voltage is adjusted in the range from 2 to 20 V and the etching time is adjusted to 100 minutes.

15. Method according to one of Claims 4 to 14, characterised in that the afteretching is carried out in 1 to 10%-strength by weight potassium hydroxide solution with an etching time of 10 minutes.

16. Method according to one of Claims 4 to 15, characterised in that the preliminary etching is carried out in 10%-strength by weight potassium hydroxide solution with an etching time of 10 minutes.

17. Application of the method according to at least one of Claims 1 to 16 for the manufacture of trenches for the reception of trench-cell capacitors (trench cells) for memory modules in the sub-µm region.

18. Application of the method according to at least one of Claims 1 to 16 for the manufacture of insulating trenches for LSI semiconductor circuits.

19. Application of the method according to at least one of Claims 1 to 16 for the manufacture of controllable capacitors (varicaps) having high capacitance.

20. Application of the method according to at least one of Claims 1 to 16 for the manufacture of vias in deeply situated layers in silicon semiconductor substrates such as those used, in particular, in turn-off thyristors, the etching current being adjusted to a range from 1 to 100 nA, the voltage to 2 V and the etching time to 100 minutes.

21. Application of the method according to Claim 20 for the manufacture of voltage-controlled thyristors, the etching current being increased by a factor of 2 to 10 after two thirds of the etching time for the purpose of hole enlargement.

22. Application of the method according to at least one of Claims 1 to 16 for the manufacture of large-area capacitors in a small volume.

## Revendications

1. Procédé pour former des ouvertures en forme de trous ou des sillons dans des couches ou des substrats constitués par du silicium dopé du type n, du genre utilisé lors de la fabrication de composants à semiconducteurs, notamment de circuits à semiconducteurs à haute densité d'intégration, au moyen d'une corrosion de préférence masquée, et selon lequel on exécute une corrosion électrolytique dans un électrolyte (3) contenant de l'acide fluorhydrique, moyennant l'application d'un potentiel constant ou variable dans le temps, la couche formée de silicium ou le substrat (1) étant branché en tant qu'électrode polarisée positivement (5) d'une cellule d'électrolyse, et selon lequel des porteurs de charges minoritaires nécessaires pour le déclenchement de l'électrolyse sont produits dans le silicium et la corrosion est exécutée tout d'abord avec de faibles écarts par rapport à la surface idéalement lisse du silicium, avec des densités de courant qui ne sont pas trop élevées dans la zone de la dissolution divalente du silicium, est amplifiée en ces endroits et forme un système de trous fins.

2. Procédé suivant la revendication 1, caractérisé par le fait que les petits écarts sont prédéterminés par un masque de corrosion.

3. Procédé suivant la revendication 2, caractérisé par le fait qu'on utilise comme masque de corrosion une couche de nitrure de silicium structurée.

4. Procédé suivant l'une des revendications 1 à 3, caractérisé par le fait qu'en supplément on exécute une corrosion chimique, de préférence dans une lessive alcaline, avant et/ou après la corrosion électrolytique.

5. Procédé suivant l'une des revendications 1 à 4, caractérisé par le fait qu'on ajoute un agent de réticulation à l'électrolyte (3).

6. Procédé suivant la revendication 5, caractérisé par le fait qu'on utilise un agent de réticulation à base de formaldéhyde.

7. Procédé suivant l'une des revendications 1 à 6, caractérisé par le fait que l'électrolyse est déclenché par éclairement (8) du corps en silicium (1) à partir de sa face arrière.

8. Procédé suivant la revendication 7, caractérisé par le fait que l'éclairement (8) est maintenu en permanence ou est modifié dans le temps afin de commander le courant de corrosion.

9. Procédé suivant l'une des revendications 1 à 8, caractérisé par le fait que la concentration en acide fluorhydrique dans l'électrolyte (3) est réglée approximativement à 2,5 pour cent en poids.

10. Procédé suivant l'une des revendications 1 à 9, caractérisé par le fait que lors de la corrosion, on utilise un autre contact (4) en plus du contact avec l'électrolyte (5), pour les porteurs de charges majoritaires.

11. Procédé suivant la revendication 10, caractérisé par le fait qu'on utilise comme contact (4) un contact ohmique.

12. Procédé suivant l'une des revendications 1 à 11, caractérisé par le fait que pour fabriquer des trous possédant un diamètre d'environ 1 µm et une profondeur d'environ 10 µm dans un substrat en silicium dopé du type n, dans la gamme de 1 ohm.cm, on règle le courant de corrosion pour chaque trou à environ 0,1 nA, la tension à 1 V et la durée de corrosion à 20 minutes.

13. Procédé suivant l'une des revendications 1 à 11, caractérisé par le fait que pour la fabrication de sillons à pores fins, qui logent des substances dopantes ainsi que pour la fabrication de condensateurs de surface étendue ou de jonctions pn dans un faible volume dans le substrat en silicium dopé du type n, dans la gamme de 0,1 à 1,0 ohm.cm, on règle le courant de corrosion à 1 nA, la tension à 2 V et la durée de corrosion à 100 minutes.

14. Procédé suivant l'une des revendications 1 à 11, caractérisé par le fait que pour la fabrication de sillons dans le substrat en silicium dopé du type n, dans la gamme de 1 à 100 ohms.cm, pour loger un matériau isolant avec un diamètre de sillon dans la gamme de 5 µm et une profondeur d'environ 20 µm, on règle le courant de corrosion à 1 nA, la tension dans la gamme de 2 à 20 V et la durée de corrosion à 100 minutes.

15. Procédé suivant l'une des revendications 4 à 14, caractérisé par le fait qu'on exécute la post-corrosion dans de la potasse caustique intervenant pour 1 à 10 pour cent en poids, avec une durée de corrosion de 10 minutes.

16. Procédé suivant l'une des revendications 4 à 15, caractérisé par le fait que la précorrosion est exécutée avec la potasse caustique intervenant pour 10 pour cent en poids avec une durée de corrosion de 10 minutes.

17. Application du procédé suivant au moins l'une des revendications 1 à 16 pour la fabrication de sillons servant à loger des condensateurs de cellules en sillons (cellule trench) pour des modules de mémoire dans la gamme inférieure au micron.

18. Application du procédé suivant au moins l'une des revendications 1 à 16 pour la fabrication de sillons isolants pour des circuits à semiconducteurs à haute densité d'intégration.

19. Application du procédé suivant au moins l'une des revendications 1 à 16 pour la fabrication de condensateurs commandables (varicaps) de grande capacité.

20. Application du procédé suivant au moins l'une des revendications 1 à 16 pour la fabrication de trous de contact par des couches assez profondes dans des substrats à semiconducteurs en silicium, du type utilisé notamment dans des thyristors débranchables, le courant de corrosion étant réglé dans une gamme de 1 à 100 nA, la tension étant réglée à 2 V et la durée de corrosion étant réglée à 100 minutes.

21. Application du procédé suivant la revendication 20 pour la fabrication de thyristors commandables par la tension, le courant de corrosion étant accru du facteur 2 à 10 au bout des deux tiers du temps de corrosion, pour élargir les trous.

22. Application du procédé suivant au moins l'une des revendications 1 à 16 pour la fabrication de condensateurs de grande surface dans un faible volume.
